# EUROPEAN PATENT SPECIFICATION

(11) **EP 4 379 405 B1**
(45) Date of publication and mention of the grant of the patent: **18.03.2026**
(21) Application number: 23824231.7
(22) Date of filing: 14.06.2023
(51) Int. Cl.: G01R 31/367, G01R 31/389, G01R 31/392, G01R 31/3835, G01R 17/02, G01R 31/36, G01R 31/396

(54) **APPARATUS AND METHOD FOR DIAGNOSING BATTERY**
VORRICHTUNG UND VERFAHREN ZUR BATTERIEDIAGNOSE
APPAREIL ET PROCÉDÉ DE DIAGNOSTIC DE BATTERIE

(30) Priority: 14.06.2022 KR 20220071950
(43) Date of publication of application: 05.06.2024
(73) Proprietor: LG Energy Solution, Ltd., Seoul 07335 (KR)
(72) Inventor: CHOI, Soon-Hyung, Daejeon 34122 (KR); KIM, Dae-Soo, Daejeon 34122 (KR); KIM, Young-Deok, Daejeon 34122 (KR)
(74) Representative: Goddar, Heinz J.
(86) International application number: PCT/KR2023/008206
(87) International publication number: WO 2023/244017

(56) References cited:
- CN-A- 113 853 706
- KR-A- 20210 011 236
- KR-A- 20220 030 824
- KR-A- 20220 060 814
- KR-B1- 100 911 315
- KR-B1- 101 458 128
- US-A1- 2006 113 959
- US-A1- 2022 231 515

## Description

### TECHNICAL FIELD

The present application claims priority to Korean Patent Application No. 10-2022-0071950 filed on June 14, 2022 in the Republic of Korea.

The present disclosure relates to an apparatus and method for diagnosing a battery, and more particularly, to an apparatus and method for diagnosing a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being conducted on these batteries in terms of high-capacity and high-density, but the aspect of improving lifespan and safety is also important. To this end, it is necessary to suppress the decomposition reaction with the electrolyte on the surface of the electrode, and it is required to prevent overcharging and overdischarging.

In particular, during the battery manufacturing process, overhang may occur where the positive electrodes and the negative electrodes are misaligned, and the overhang may be one of the causes of lithium plating (Li-plating), which is a phenomenon that lithium precipitation occurs on the surface of the negative electrode. When lithium precipitation occurs on the surface of the negative electrode, it causes side reactions with the electrolyte and changes in the kinetic balance of the battery, which causes battery degradation. In addition, since an internal short circuit of the battery may occur as lithium metal precipitation occurs on the surface of the negative electrode, there is a risk of ignition and explosion due to the internal short circuit. Prior art document US2006/113959 discloses an arrangement comprising a battery, where battery voltage and current are digitized and used for calculating the battery internal resistance while the battery is being charged at a predetermined current in a repetitive, pulsed fashion. A resistance profile over the State of Charge range of the battery is formed, and only the relatively stable resistance values in the middle of the SoC range are used. To judge the battery life or health, the measured resistance value is compared to an initial measured value.

Therefore, there is a need to develop a technology that can diagnose the state of the battery by considering whether overhang occurs and/or the degree of overhang.

### DISCLOSURE

### Technical Problem

The present disclosure is designed to solve the problems of the related art, and therefore the present disclosure is directed to providing an apparatus according to claim 1 and a method according to claim 13 for diagnosing a battery with an overhang.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure comprises a measuring unit configured to measure a voltage value of the battery at each predetermined cycle during a battery charging process; and a processor configured to calculate a resistance value of the battery based on the measured voltage value of the battery, determine a resistance change pattern by comparing the calculated plurality of resistance values with a preset criterion profile, and determine the state of the battery based on the determined resistance change pattern.

Here, the criterion profile may be a profile that represents the change in the plurality of resistance values calculated in a charging process of a criterion battery at each predetermined cycle.

According to the invention, the processor is configured to generate a resistance profile representing the change in the calculated plurality of resistance values, and compare the generated resistance profile with the criterion profile to determine the resistance change pattern as a first resistance change pattern or a second resistance change pattern.

In addition, the processor may be configured to calculate a first slope from the resistance profile, calculate a second slope from the criterion profile, and determine the resistance change pattern according to the result of comparing the first slope and the second slope.

In addition, when the first slope at a charging end time point on the resistance profile is less than the second slope at a charging end time point on the criterion profile, the processor may be configured to determine the resistance change pattern as the first resistance change pattern, and when the first slope is greater than or equal to the second slope, the processor may be configured to determine the resistance change pattern as the second resistance change pattern.

In addition, when the first slope based on a first point corresponding to a charging end time point on the resistance profile and a second point different from the first point is less than the second slope based on a third point corresponding to the first point and a fourth point corresponding to the second point on the criterion profile, the processor may be configured to determine the resistance change pattern as the first resistance change pattern, and when the first slope is greater than or equal to the second slope, the processor may be configured to determine the resistance change pattern as the second resistance change pattern.

In addition, the processor may be configured to generate a SOC-resistance profile that represents the correspondence relationship between a SOC of the battery and the calculated resistance value in the battery charging process, determine a target resistance value corresponding to the predetermined SOC in the SOC-resistance profile, and determine a point corresponding to the target resistance value in the resistance profile as the second point.

In addition, the processor may be configured to determine a reference resistance value corresponding to the predetermined SOC in a criterion SOC-resistance profile corresponding to the criterion profile, and determine a point corresponding to the reference resistance value in the criterion profile as the fourth point.

In addition, the processor may be configured to determine a peak belonging to a predetermined SOC section in a differential profile corresponding to the SOC of the battery and the voltage value of the battery, and determine a SOC corresponding to the determined peak as the predetermined SOC.

In addition, when the resistance change pattern is the first resistance change pattern, the processor may be configured to determine that the battery is in a defective state, and when the resistance change pattern is the second resistance change pattern, the processor may be configured to determine that the battery is in a normal state.

In addition, the processor may be configured to charge the battery while repeatedly changing a charging current value of the battery at every predetermined cycle, and calculate the resistance value based on the change in voltage value while the charging current value of the battery corresponds to a predetermined value.

In addition, a battery pack according to another aspect of the present disclosure may comprise the apparatus for diagnosing a battery according to the present disclosure.

In addition, a vehicle according to still another aspect of the present disclosure may comprise the apparatus for diagnosing a battery according to the present disclosure.

In addition, a method for diagnosing a battery corresponding to the apparatus of the first aspect is provided.

### Advantageous Effects

According to one aspect of the present disclosure, it is possible to diagnose a defective battery in which lithium is precipitated due to overhang that has occurred during the manufacturing process.

In addition, according to one aspect of the present disclosure, there is an advantage of quickly determining a defective battery in which lithium is precipitated due to overhang just by the change pattern of the resistance value obtained during the battery charging process.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram exemplarily showing an apparatus for diagnosing a battery according to an embodiment of the present disclosure.
FIG. 2 is an example of the charging current applied to a battery during the battery charging process.
FIG. 3 is an example of a criterion voltage profile indicating the voltage value of the criterion battery and a criterion profile indicating the resistance value of the criterion battery during the process of charging the criterion battery.
FIG. 4 is a graph showing an example of a processor determining a resistance change pattern using a resistance profile according to an embodiment of the present disclosure.
FIG. 5 is a graph showing an example of a processor determining a resistance change pattern using a resistance profile according to various embodiments of the present disclosure.
FIG. 6 is a graph showing an example of a SOC-resistance profile and a criterion SOC-resistance profile according to an embodiment of the present disclosure.
FIG. 7 is an example of a differential profile showing the correspondence relationship between differential voltage and SOC based on the SOC and voltage of the battery.
FIG. 8 is a diagram exemplarily showing a battery pack including the apparatus for diagnosing a battery according to the present disclosure.
FIG. 9 is a diagram exemplarily showing a vehicle including the apparatus for diagnosing a battery according to the present disclosure.
FIG. 10 is a diagram schematically showing a method for diagnosing a battery according to an embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

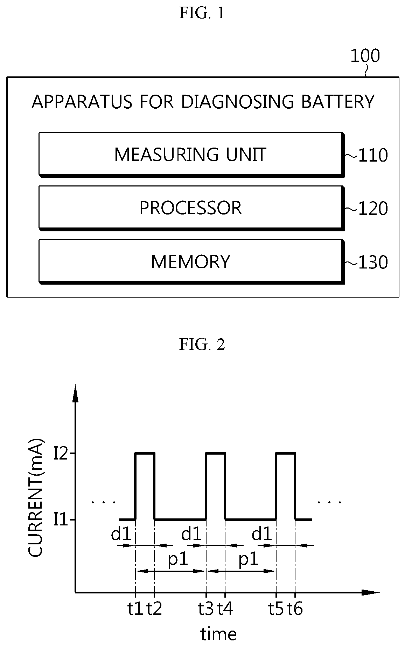

FIG. 1 is a diagram exemplarily showing an apparatus 100 for diagnosing a battery according to an embodiment of the present disclosure.

Referring to FIG. 1, the apparatus 100 for diagnosing a battery may include a measuring unit 110, a processor 120, and a memory 130.

The measuring unit 110 may be configured to measure the voltage value of the battery at every predetermined cycle during the battery charging process. Here, the battery refers to an independent cell that has a negative terminal and a positive terminal and is physically separable. As an example, a lithium-ion battery or a lithium polymer battery may be considered as a battery. Additionally, the battery may mean a battery module in which a plurality of cells are connected in series and/or parallel. Below, for convenience of explanation, the battery is explained as meaning one independent cell.

The measuring unit 110 may employ various voltage measurement techniques known at the filing time of the present disclosure. For example, the measuring unit 110 may include a voltage sensor known at the filing time of the present disclosure. In particular, when the apparatus 100 for diagnosing a battery according to the present disclosure is applied to a battery pack, a voltage sensor already included in the battery pack may be used as the measuring unit 110 according to the present disclosure.

The measuring unit 110 may measure the voltage value of the battery at each predetermined cycle while the battery is being charged, based on the control of the processor 120. Specifically, the processor 120 can control the charging current to be applied to the battery so that the battery is charged. In one example, the processor 120 may cause the charging current applied to charge the battery to be applied to the battery in the form of a pulse.

The processor 120 may charge the battery by repeatedly changing the charging current value of the battery at each predetermined cycle. FIG. 2 is an example of the charging current applied to a battery during the battery charging process. The x-axis of the graph in FIG. 2 is time, and the y-axis is the current value of the charging current. The processor 120 can charge the battery with the first current value I1 and allow a pulse current of the second current value I2 to be applied to the battery at every predetermined cycle. That is, the current of the second current value I2 can be applied to the battery during the first time t1 to the second time t2, the third time t3 to the fourth time t4, and the fifth time t5 to the sixth time t6, and the current of the first current value I1 can be applied to the battery during the second time t2 to the third time t3 and the fourth time t4 to the fifth time t5. Here, the predetermined cycle in which the pulse current is applied may be the first cycle P1, and the duration in which the pulse current is applied may be the first time interval d1. The duration in which the pulse current is applied can correspond to various values such as 0.1 second, 0.5 second, or 1 second. Alternatively, in various embodiments, the processor 120 may set the charging current to have an idle time where the current is 0. For example, although not shown in FIG. 2, a predetermined amount of current may be applied to the battery during the first time t1 to the second time t2, the third time t3 to the fourth time t4, the fifth time t5 to the sixth time t6, and the current value may be 0 during the second time t2 to the third time t3 and the fourth time t4 to the fifth time t5. Below, for convenience of explanation, an example in which the battery is charged without idle time is explained.

The processor 120 may calculate the resistance value based on the change in voltage value while the charging current value of the battery corresponds to a predetermined value. Specifically, the measuring unit 110 can measure the voltage value of the battery at each of the start time and end time at which the current of the second current value I2 is applied, when the pulse current is applied to the battery at every predetermined cycle. For example, the measuring unit 110 may measure the voltage value of the battery at the first time t1 and measure the voltage value of the battery at the second time t2. Afterwards, the measuring unit 110 may measure the voltage value of the battery again at the third time t3 and measure the voltage value of the battery again at the fourth time t4 to measure the voltage value of the battery at each predetermined cycle (e.g., the first cycle P1). The measuring unit 110 may transmit the measured voltage value to the processor 120. The processor 120 may calculate the resistance value based on the change in voltage value.

The processor 120 may obtain the voltage value of the battery measured by the measuring unit 110. The processor 120 may calculate the resistance value of the battery based on the measured voltage value of the battery. Specifically, the processor 120 may calculate the resistance value of the battery at each predetermined cycle (e.g., the first cycle P1) while the battery is being charged. The processor 120 may calculate the battery voltage difference and divide the calculated voltage difference by the charging current value to calculate the battery resistance value at each predetermined cycle.

The processor 120 may calculate the resistance value of the battery using the measured voltage value of the battery as described with reference to FIG. 2. Specifically, the processor 120 may calculate the difference between the first voltage value corresponding to the voltage value of the battery at the first time t1 and the second voltage value corresponding to the voltage value of the battery at the second time t2. The processor 120 may calculate the resistance value of the battery using Ohm's law (R = ΔV ÷ ΔI). For example, the processor 120 may calculate the resistance value by dividing the difference in the calculated voltage values (e.g., ΔV) by the amount of current applied between the first time t1 and the second time t2 (e.g., ΔI = I2 × (t2 - t1)). The processor 120 may calculate a plurality of resistance values by calculating the resistance value of the battery at each predetermined cycle in the manner described above. As an example, the resistance value calculated by the processor 120 may correspond to DCIR (Direct current internal resistance).

The processor 120 may determine a resistance change pattern by comparing the calculated plurality of resistance values with a preset criterion profile. Here, the criterion profile may be a profile representing the change in resistance value extracted through a charging process in advance for a battery of the same type or a battery (hereinafter referred to as a criterion battery) designed to have the same characteristics as the battery that is the subject of diagnosis. The criterion profile can be stored in advance in the memory 130.

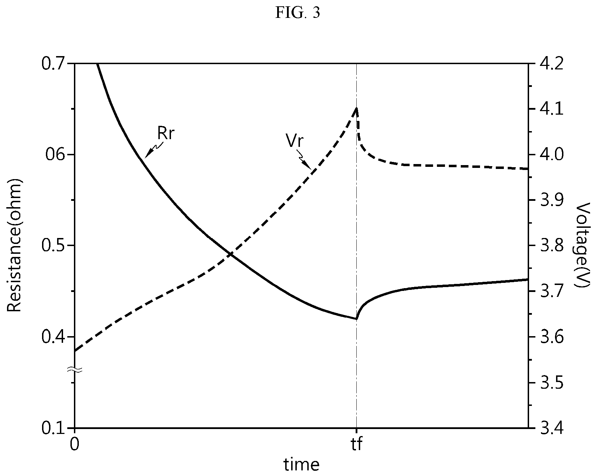

FIG. 3 is an example of a criterion voltage profile Vr indicating the voltage value of the criterion battery and a criterion profile Rr indicating the resistance value of the criterion battery during the process of charging the criterion battery. For example, in the embodiment of FIG. 3, the criterion voltage profile Vr can be expressed as an X-Y graph where the X-axis is time and the Y-axis is voltage value. Likewise, the criterion profile Rr can be expressed as an X-Y graph where the X-axis is time and the Y-axis is voltage value.

The criterion profile Rr may be a profile representing the change in the plurality of resistance values calculated in the charging process of the criterion battery at each predetermined cycle. The criterion profile Rr may be a graph showing the resistance value of the criterion battery calculated under the same conditions so that the processor 120, described later, can compare it with the resistance value of the battery that is the subject of diagnosis. For example, the criterion profile Rr may be a graph showing the resistance value calculated using the voltage values of the criterion battery measured by making the measurement time and measurement cycle identically, when the criterion battery is charged with the same charging current as the charging current of the battery that is the subject of diagnosis, in the same manner as described with reference to FIG. 2. Meanwhile, in FIG 3, the criterion voltage profile Vr and the criterion profile Rr are displayed on one plane for convenience of explanation.

Referring to the criterion voltage profile Vr of the criterion battery, it can be seen that in the criterion battery charging process, the voltage value of the criterion battery gradually increases until the time point tf when the charging ends. Referring to the criterion profile Rr of the criterion battery, it can be seen that in the criterion battery charging process, the resistance value of the criterion battery gradually decreases from the start of charging to the time point tf when the charging ends.

The processor 120 may determine a resistance change pattern by comparing the plurality of resistance values with the criterion profile described above, as described with reference to FIG. 2. Specifically, the processor 120 may compare the slope of the criterion profile with the slope of the profile indicating a change in the resistance value of the battery to be diagnosed based on a specific point.

The processor 120 may determine the state of the battery based on the determined resistance change pattern.

If the resistance change pattern is determined to be the first resistance change pattern, the processor 120 may determine the state of the battery that is the subject of diagnosis as a defective state. Here, the first resistance change pattern may be a pattern with a slope less than the slope of the criterion profile. Specifically, when an overhang occurs in the battery, lithium may precipitate on the negative electrode, resulting in a pattern in which the resistance value decreases at the end of the charging process. Preferably, when an overhang exceeding the criterion rate occurs in the battery, a pattern in which the resistance decreases may appear at the end of the charging process. If the resistance change pattern is the first resistance change pattern, the processor 120 may determine the state of the battery as a defective state in which an overhang has occurred.

For example, the criterion rate can be set to a value of 3% or higher. Preferably, the criterion rate can be set to any value between 3% and 5%. However, note that the criterion ratio is not interpreted as being limited by the above-mentioned exemplary values.

If the resistance change pattern is determined to be the second resistance change pattern, the processor 120 may determine the state of the battery that is the subject of diagnosis as a normal state. Here, the second resistance change pattern may be a pattern having a slope greater than or equal to the slope of the criterion profile.

That is, the apparatus 100 for diagnosing a battery according to an embodiment of the present application can specifically distinguish the resistance change pattern of the battery in the charging process into a first resistance change pattern or a second resistance change pattern. Also, the apparatus 100 for diagnosing a battery can diagnose the state of the battery based on the resistance change pattern of the battery. Therefore, the apparatus 100 for diagnosing a battery has an advantage of quickly diagnosing the state of the battery during the charging process.

Hereinafter, various embodiments in which the processor 120 determines a resistance change pattern are described using the drawings.

The processor 120 is operatively connected to other components of the apparatus 100 for diagnosing a battery and may control various operations of the apparatus 100 for diagnosing a battery. The processor 120 may perform various operations of the apparatus 100 for diagnosing a battery by executing one or more instructions stored in the memory 130. The processor 120 may optionally include a processor 120, an application-specific integrated circuit (ASIC), a chipset, a logic circuit, a register, a communication modem, a data processing device, etc. known in the art to execute various control logics performed in the present disclosure. Also, when the control logic is implemented as software, the processor 120 may be implemented as a set of program modules. At this time, the program module may be stored in the memory 130 and executed by the processor 120.

In particular, when the apparatus 100 for diagnosing a battery according to the present disclosure is implemented in a form included in a battery pack, the battery pack may include a control device referred to by terms such as a micro controller unit (MCU) or a battery management system (BMS). At this time, the processor 120 may be implemented by a component such as an MCU or BMS included in such a general battery pack. In addition, in this specification, terms such as 'do ...' or 'configured to ...' regarding the operation or function of the processor 120 may include the meaning of 'programmed to ...'.

The memory 130 can be configured to store predetermined data. In particular, in the present disclosure, the memory 130 can store the criterion profile in advance. The criterion profile may be a profile that serves as a criterion for comparison with the resistance value of the battery to be diagnosed. In other words, the criterion profile may respond to the trend of the resistance value calculated using the charging current value after measuring the voltage value of the criterion battery in the charging process of the criterion battery, in the same way as the method used to calculate the voltage value of the battery to be diagnosed. As an example, the criterion profile has already been described with reference to FIG. 3, so redundant description will be omitted.

The memory 130 may store data required for each component of the battery control apparatus 100 to perform operations and functions, or data generated in the process of performing programs or operations and functions. The memory 130 may be internal or external to the processor 120, and may be connected to the processor 120 by various well-known means. The memory 130 may store at least one program, application, data, or instructions executed by the processor 120. The type of memory 130 is not particularly limited as long as it is known information storage means capable of recording, erasing, updating, and reading data. As an example, the memory 130 may be implemented as at least one of a flash memory type, a hard disk type, a solid state disk (SSD) type, a solid disk drive (SDD) type, a multimedia card micro type, a random access memory (RAM), and a static RAM (SRAM), a ROM (Read Only Memory), an EEPROM (Electrically Erasable Programmable Read Only Memory), and a PROM (Programmable Read Only Memory), but the present disclosure is not necessarily limited to the specific form of the memory 130. Also, the memory 130 may store program codes in which processes executable by the processor 120 are defined.

According to this configuration of the present disclosure, the state of the battery can be easily diagnosed based on the change in resistance values at the end of the charging process of the battery. Hereinafter, referring to the drawings, various embodiments in which the processor 120 determines the state of the battery using a resistance change pattern will be described.

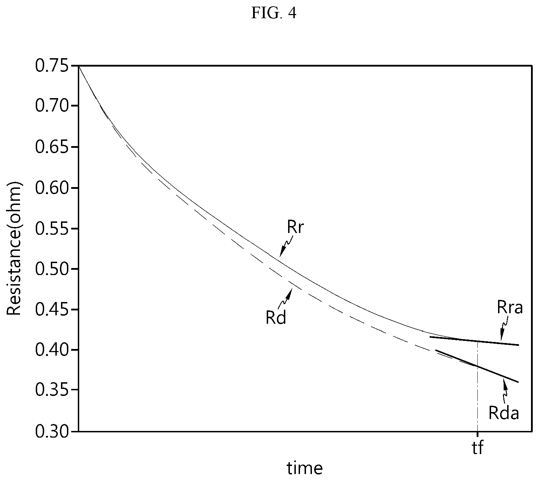

The processor 120 may generate a resistance profile indicating the change in the calculated plurality of resistance values. This will be described in more detail with reference to FIG. 4.

FIG. 4 is a graph showing an example of a processor 120 determining a resistance change pattern using a resistance profile according to an embodiment of the present disclosure. For this embodiment and other embodiments below, description will be focused on parts that are different from those described above, and detailed descriptions will be omitted for parts where the same or similar descriptions can be applied.

Referring to FIG. 4, the criterion profile Rr for the criterion battery is shown, similar to that described in FIG. 2. Here, the processor 120 may calculate a plurality of resistance values using the voltage value measured at each predetermined cycle of the battery being diagnosed, and generate a resistance profile Rd indicating a change pattern of the calculated plurality of resistance values.

The processor 120 may determine the resistance change pattern as the first resistance change pattern or the second resistance change pattern by comparing the generated resistance profile Rd and the criterion profile Rr.

Specifically, the processor 120 may determine a resistance change pattern by comparing the slopes of the resistance profile Rd and the criterion profile Rr to increase the accuracy of battery diagnosis.

For example, the processor 120 may determine the resistance change pattern as the first resistance change pattern or the second resistance change pattern according to the slope of the resistance profile Rd.

The processor 120 may calculate the first slope from the resistance profile Rd and the second slope from the criterion profile Rr. Also, the processor 120 may determine the resistance change pattern according to the result of comparing the first slope and the second slope. The processor 120 may calculate the first slope by recognizing the instant slope at a predetermined point of the resistance profile Rd. The processor 120 may calculate the second slope by recognizing the instant slope at a point corresponding to the predetermined point in the criterion profile Rr. The processor 120 may determine the resistance change pattern as the first resistance change pattern when the first slope is less than the second slope. The processor 120 may determine the resistance change pattern as the second resistance change pattern when the first slope is greater than or equal to the second slope. This will be described in more detail with reference to FIG. 4.

If the first slope of the time point tf at which the charging ends on the resistance profile Rd is less than the second slope of the time point tf at which the charging ends on the criterion profile Rr, the processor 120 may determine the resistance change pattern as the first resistance change pattern. The first slope of the time point tf at which the charging ends on the resistance profile Rd may correspond to the instant slope of the time point tf at which the charging ends. Additionally, the second slope of the time point tf at which the charging ends on the criterion profile Rr may correspond to the instant slope of the time point tf at which the charging ends.

Referring to FIG. 4, the tangent line Rda of the time point tf at which the charging ends on the resistance profile Rd and the tangent line Rra of the time point tf at which the charging ends on the criterion profile Rr are indicated. Since the first slope corresponding to the slope of the tangent line Rda is less than the second slope corresponding to the slope of the tangent line Rra, the processor 120 may determine the resistance change pattern as the first resistance change pattern. In various embodiments, when the difference value between the first slope and the second slope exceeds a predetermined range, the processor 120 may determine the resistance change pattern as the first resistance change pattern.

If the resistance change pattern is the first resistance change pattern, the processor 120 may determine that the state of the battery is a defective state.

For example, the first resistance change pattern is a pattern in which the first slope is less than the second slope, and may be a pattern in which the resistance value of the battery decreases.

As another example, the first resistance change pattern may be a pattern in which the first slope is less than the second slope and the difference value between the first slope and the second slope is greater than or equal to the threshold value. The processor 120 may calculate the difference value by calculating the formula "second slope - first slope". Also, if the calculated difference value is greater than or equal to a preset threshold value, the processor 120 may determine the resistance change pattern as the first resistance change pattern.

The processor 120 may diagnose the battery determined to have the first resistance change pattern as a battery in a defective state. In other words, the processor 120 may diagnose the battery determined to have the first resistance change pattern as an abnormal battery in which the overhang occurs greater than or equal to the criterion rate.

If the first slope of the time point tf at which the charging ends on the resistance profile Rd is greater than or equal to the second slope of the time point tf at which the charging ends on the criterion profile Rr, the processor 120 may determine the resistance change pattern as the second resistance change pattern.

For example, the second resistance change pattern may be a pattern where the first slope is greater than or equal to the second slope. The processor 120 may determine the resistance change pattern as the second resistance change pattern when the first slope decreases but the first slope is greater than or equal to the second slope.

As another example, in the second resistance change pattern, when the first slope is less than the second slope but the difference value between the first slope and the second slope is less than the threshold value, the processor 120 may determine the resistance change pattern as the second resistance change pattern. The processor 120 may calculate the difference value by calculating the formula "second slope - first slope". Also, if the calculated difference value is less than a preset threshold value, the processor 120 may determine the resistance change pattern as the second resistance change pattern. That is, the processor 120 may determine the resistance change pattern as the second resistance change pattern when the first slope is less than the second slope but the decrease in the first slope is less than a certain level compared to the second slope.

If the resistance change pattern is the second resistance change pattern, the processor 120 may determine that the state of the battery is a normal state. Specifically, the processor 120 may diagnose the battery determined to have the second resistance change pattern as a battery in a normal state. That is, the processor 120 may diagnose the battery determined to have the second resistance change pattern as a normal battery in which no overhang has occurred. Alternatively, the processor 120 may diagnose the battery determined to have the second resistance change pattern as a normal battery in which an overhang occurs less than the criterion rate. In this way, the processor 120 may diagnose whether an overhang of the battery occurs during battery charging only based on the resistance change pattern at the charging end.

The apparatus 100 for diagnosing a battery according to an embodiment of the present disclosure can divide the resistance change pattern of the battery according to the increase or decrease in the first slope and the difference between the first slope and the second slope. Additionally, the apparatus 100 for diagnosing a battery can diagnose the state of the battery according to a divided resistance change pattern. Therefore, the apparatus 100 for diagnosing a battery has an advantage of not only quickly diagnosing the state of the battery during the charging process, but also diagnosing the state of the battery in detail.

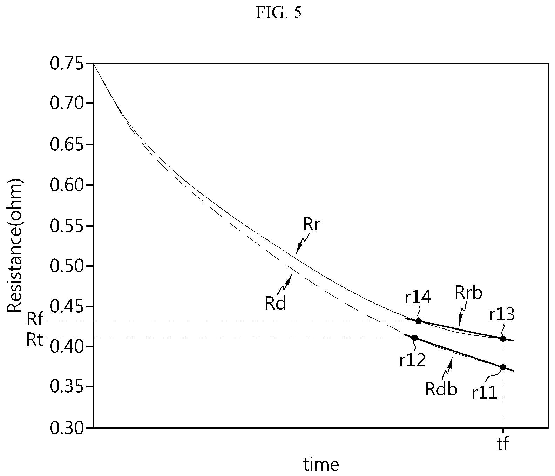

Hereinafter, with reference to FIG. 5, another embodiment in which the processor 120 determines a resistance change pattern will be described in detail. For convenience of explanation, note that the content of diagnosing the state of the battery according to the resistance change pattern determined by the processor 120 overlaps with the above-mentioned content, and will therefore be briefly described or omitted.

FIG. 5 is a graph showing an example of a processor 120 determining a resistance change pattern using a resistance profile according to various embodiments of the present disclosure.

Referring to FIG. 5, the criterion profile Rr for the criterion battery and the resistance profile Rd generated by the processor 120 are shown, similar to those described in FIG. 4.

When the first slope based on the first point r11 corresponding to the time point tf at which the charging ends on the resistance profile Rd and the second point r12 different from the first point r11 is less than the second slope based on the third point r13 on the criterion profile Rr corresponding to the first point and the fourth point r14 on the criterion profile Rr corresponding to the second point r12, the processor 120 may determine the resistance change pattern as the first resistance change pattern.

Specifically, the processor 120 may generate a first straight line Rdb based on the first point r11 and the second point r12 on the resistance profile Rd. For example, the first straight line Rdb may be a straight line including the first point r11 and the second point r12. That is, the first straight line Rdb may be a straight line connecting the first point r11 and the second point r12.

The processor 120 may generate a second straight line Rrb based on the third point r13 and the fourth point r14 on the criterion profile Rr. For example, the second straight line Rrb may be a straight line including the third point r13 and the fourth point r14. That is, the second straight line Rrb may be a straight line connecting the third point r13 and the fourth point r14.

Here, the first point r11 and the third point r13 may be points corresponding to the same time. Specifically, the fact that first point r11 corresponds to the third point r13 means that the first point r11 corresponds to the resistance value of the battery that is the subject of diagnosis at the time point tf when the charging ends on the resistance profile Rd, and the third point r13 corresponds to the resistance value of the criterion battery at the time point tf when the charging ends.

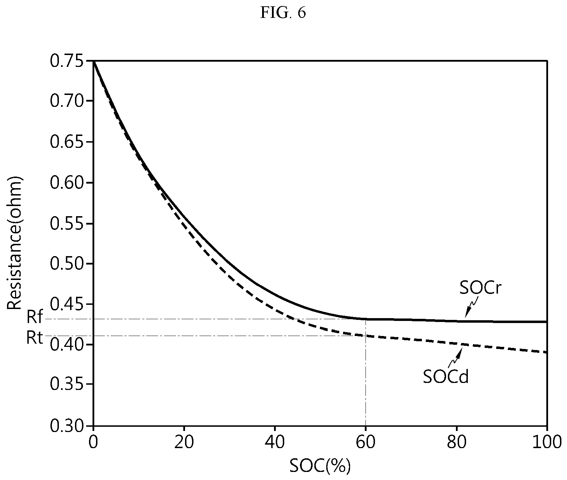

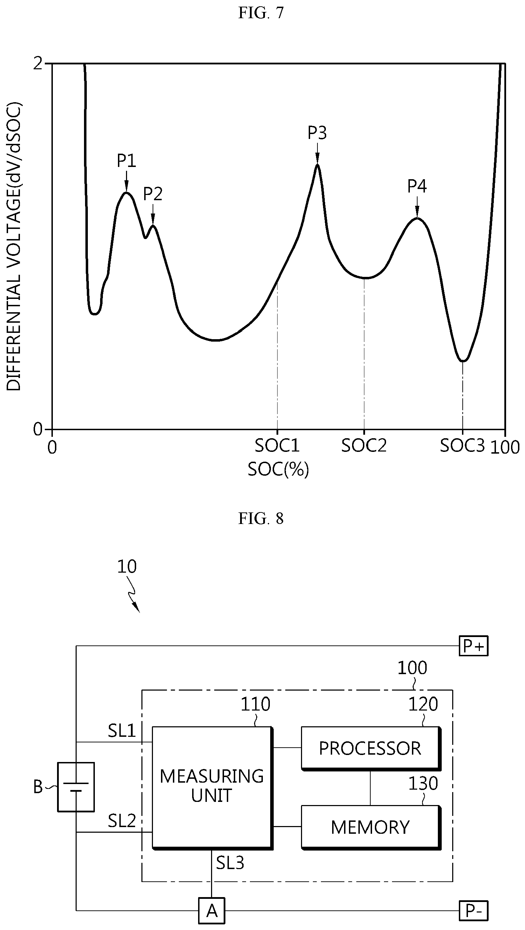

Additionally, the second point r12 and the fourth point r14 may be corresponding points for the same SOC. Specifically, the fact that second point r12 corresponds to the fourth point r14 means that the second point r12 corresponds to the resistance value of the battery that is the subject of diagnosis corresponding to the predetermined SOC, and the fourth point r14 corresponds to the resistance value of the criterion battery that corresponds to the predetermined SOC. An embodiment in which the second point r12 and the fourth point r14 are determined will be described later using FIGS. 6 and 7.

Referring to FIG. 5, the first straight line Rdb and the second straight line Rrb are indicated. Based on the fact that the first slope of the first straight line Rdb is less than the second slope of the second straight line Rrb, the processor 120 may determine the resistance change pattern as the first resistance change pattern. Here, the first resistance change pattern may be a pattern in which the resistance value decreases. In various embodiments, when the difference value between the first slope of the first straight line Rdb and the second slope of the second straight line Rrb exceeds a predetermined range, the processor 120 may determine the resistance change pattern as the first resistance change pattern. The processor 120 can diagnose the battery determined to have the first resistance change pattern as a battery in a defective state. In other words, the processor 120 can diagnose the battery determined to have the first resistance change pattern as an abnormal battery in which overhang has occurred greater than or equal to the criterion rate.

If the first slope is greater than or equal to the second slope, the processor 120 may determine the resistance change pattern as the second resistance change pattern.

For example, if the first slope of the first straight line Rdb is greater than or equal to the second slope of the second straight line Rrb, the processor 120 may determine the resistance change pattern as the second resistance change pattern.

As another example, if the difference between the first slope of the first straight line Rdb and the second slope of the second straight line Rrb is less than the threshold value, the processor 120 may determine the resistance change pattern as the second resistance change pattern.

Additionally, the processor 120 may diagnose the battery determined to have the second resistance change pattern as a battery in a normal state. That is, the processor 120 can diagnose the battery determined to have the second resistance change pattern as a normal battery in which no overhang has occurred. Alternatively, the processor 120 may diagnose the battery determined to have the second resistance change pattern as a normal battery in which overhang has occurred less than the criterion rate.

The apparatus 100 for diagnosing a battery according to an embodiment of the present disclosure can easily diagnose the state of the battery using not only the instant slope at the charging end, but also the average slope at the charging end and a predetermined point. In other words, the apparatus 100 for diagnosing a battery has an advantage of diagnosing the state of the battery more accurately by considering the change in battery resistance from various aspects (particularly, time point).

Hereinafter, an embodiment in which the processor 120 determines the second point r12 and the fourth point r14 is described.

The processor 120 may generate a SOC-resistance profile representing the correspondence relationship between the SOC (state of charge) of the battery and the resistance value during the battery charging process. Additionally, the processor 120 may obtain a criterion SOC-resistance profile indicating the correspondence relationship between the SOC of the criterion battery and the resistance value in the charging process of the criterion battery. Here, the criterion SOC-resistance profile may be a profile representing the correspondence relationship between the resistance value and the SOC extracted through the charging process of the criterion battery in advance. The criterion SOC-resistance profile can be stored in advance in the memory 130. In other words, the criterion profile described above is also a profile obtained from the charging process of the criterion battery, and the criterion profile may correspond to the criterion SOC-resistance profile.

FIG. 6 is a graph showing an example of a SOC-resistance profile SOCd and a criterion SOC-resistance profile SOCr according to an embodiment of the present disclosure.

Referring to FIG. 6, the x-axis of the graph is SOC, and the y-axis is resistance value. Here, the unit of the x-axis is expressed as a percentage (%), but may also be expressed as a number from 0 to 1.

The processor 120 may calculate the SOC of the battery at each predetermined cycle in the battery charging process and map the calculated SOC to the resistance value of the battery measured in the above-described manner to generate a SOC-resistance profile SOCd. FIG. 6 shows the SOC-resistance profile SOCd generated by the processor 120 and the criterion SOC-resistance profile SOCr previously stored in the memory 130.

The processor 120 may determine the target resistance value Rt corresponding to the predetermined SOC from the generated SOC-resistance profile SOCd. For example, a predetermined SOC may correspond to approximately 60%, but this value is not limited. In more detail, the content in which the processor 120 determines the predetermined SOC is explained using FIG. 7, which will be described later.

The processor 120 may determine the point corresponding to the target resistance value Rt in the resistance profile as the second point. Specifically, the processor 120 may determine the target resistance value Rt corresponding to the predetermined SOC, and determine the point corresponding to the target resistance value Rt on the resistance profile Rd as the second point r12, as described with reference to FIG. 5. That is, the processor 120 may determine the point at which the battery has the resistance value Rt corresponding to a predetermined SOC (e.g., 60%) on the resistance profile Rd as the second point r12 for calculating the average slope.

Meanwhile, the processor 120 can use the criterion SOC-resistance profile to determine the fourth point r14 of the second straight line Rrb for obtaining the average slope.

The processor 120 may determine a reference resistance value corresponding to a predetermined SOC from the criterion SOC-resistance profile corresponding to the criterion profile. Specifically, the processor 120 may determine a reference resistance value Rf corresponding to the same SOC as the SOC for determining the target resistance value Rt on the criterion SOC-resistance profile. Here, since the object of comparison is selected, it is desirable to determine the target resistance value Rt and reference resistance value Rf with the same SOC.

The processor 120 may determine the point corresponding to the reference resistance value in the criterion profile as the fourth point. Specifically, the processor 120 may determine the reference resistance value Rf corresponding to the predetermined SOC, and determine the point corresponding to the reference resistance value Rf on the criterion profile Rr as the fourth point r14, as described with reference to FIG. 5. That is, the processor 120 may determine the point at which the battery has a resistance value corresponding to a predetermined SOC (e.g., 60%) on the criterion profile Rr as the fourth point r14 for calculating the average slope. In this way, the processor 120 may use the point corresponding to the charging end time point and the point at which the SOC of the battery reaches the predetermined SOC in the resistance profile Rd and the criterion profile Rr to determine the resistance change pattern. In addition, the processor 120 may use a differential profile when determining a predetermined SOC used to determine a resistance change pattern. Below, a detailed embodiment is described using FIG. 7.

FIG. 7 is an example of a differential profile showing the correspondence relationship between differential voltage and SOC based on the SOC and voltage of the battery.

The processor 120 may be configured to generate a differential profile indicating the correspondence relationship between the differential voltage and the SOC.

Here, the differential voltage is a value obtained by differentiating the voltage of the battery by SOC and can be expressed as dV/dSOC. In other words, the differential voltage may correspond to a value representing the instant change rate of voltage with respect to SOC.

The differential profile can be expressed as an X-Y graph where the X-axis is SOC and the Y-axis is differential voltage value. The differential profile may include a plurality of peaks P1, P2, P3, P4. For example, the processor 120 can detect the first peak P1, the second peak P2, the third peak P3, and the fourth peak P4. Here, the peak may be a point with an upward convex shape in the differential profile.

The processor 120 may determine the peak belonging to a predetermined SOC section in the differential profile corresponding to the SOC of the battery and the voltage value of the battery.

Referring to FIG. 7, as an example, the processor 120 may determine a section between the first SOC SOC1 and the second SOC SOC2 as a predetermined SOC section and determine a peak belonging to the section. For example, the first SOC SOC1 may be 50%, and the second SOC SOC2 may be 70%. In this case, the predetermined SOC section may be a section between 50% and 70%, but the interpretation is not limited to these values. Referring to FIG. 7, the processor 120 may determine the third peak P3 as a peak for determining the target resistance value Rt and the reference resistance value Rf. That is, the third peak P3 can be determined as a target peak for determining the target resistance value Rt and the reference resistance value Rf. In various embodiments, when the processor 120 determines a section between the first SOC SOC1 and the third SOC SOC3 as a predetermined SOC section, the third peak P3 and the fourth peak P4 may belong to the corresponding section. In this case, the processor 120 may determine the third peak P3, which has a relatively large differential voltage value (dV/dSOC), as the peak for determining the target resistance value Rt and the reference resistance value Rf. Alternatively, the processor 120 may determine the peak with the largest differential voltage value (e.g., third peak P3) among the peaks in all sections of the differential profile as the peak for determining the target resistance value Rt and the reference resistance value Rf.

The processor 120 may determine the SOC corresponding to the determined peak as a predetermined SOC. For example, referring to FIG. 7, the processor 120 may determine the third peak P3 as a peak for determining the target resistance value Rt and the reference resistance value Rf. The processor 120 may determine the SOC corresponding to the third peak P3 as a predetermined SOC. For example, the predetermined SOC may be 60%. As described with reference to FIG. 6, the processor 120 may determine a target resistance value Rt and a reference resistance value Rf corresponding to the predetermined SOC determined in the SOC-resistance profile SOCd and the criterion SOC-resistance profile SOCr. Specifically, the processor 120 may determine the resistance value of the point where SOC is 60% on the SOC-resistance profile SOCd as the target resistance value Rt. Additionally, the processor 120 may determine the resistance value of the point where SOC is 60% on the criterion SOC-resistance profile SOCr as the reference resistance value Rf.

As described with reference to FIG. 5, the processor 120 may determine the second point r12 on the resistance profile Rd, corresponding to the determined target resistance value Rt. Likewise, the processor 120 may determine the fourth point r14 on the criterion profile Rr, corresponding to the determined reference resistance value Rf.

According to this embodiment of the present disclosure, the processor 120 can determine a resistance change pattern by detecting the change in resistance cyclically calculated in the charging process of the battery, and can easily determine the state of the battery according to the determined resistance change pattern.

The apparatus 100 for diagnosing a battery according to the present disclosure can be applied to the BMS. In other words, the BMS according to the present disclosure may include the above-described apparatus 100 for diagnosing a battery. In this configuration, at least some of the components of the apparatus 100 for diagnosing a battery may be implemented by supplementing or adding functions of components included in a conventional BMS. For example, the measuring unit 110, the processor 120, and the memory 130 of the apparatus 100 for diagnosing a battery may be implemented as components of a BMS.

FIG. 8 is a diagram exemplarily showing a battery pack 10 including the apparatus 100 for diagnosing a battery according to the present disclosure. Referring to FIG. 8, the apparatus 100 for diagnosing a battery according to the present disclosure may be applied to a battery pack. That is, the battery pack 10 according to the present disclosure may include the apparatus 100 for diagnosing a battery according to the present disclosure and at least one battery cell B. In addition, the battery pack 10 according to the present disclosure may further include, in addition to the apparatus 100 for diagnosing a battery according to the present disclosure, components normally included in the battery pack 10, such as one or more secondary batteries, a battery management system (BMS), a current sensor, a relay, a fuse, a pack case, and the like. In addition, at least some components of the apparatus 100 for diagnosing a battery according to the present disclosure may be implemented as conventional components included in the battery pack 10. For example, the measuring unit 110 of the apparatus 100 for diagnosing a battery according to the present disclosure may be implemented by a voltage sensor included in the battery pack 10. In addition, at least some functions or operations of the processor 120 of the apparatus 100 for diagnosing a battery according to the present disclosure may be implemented by the BMS included in the battery pack 10.

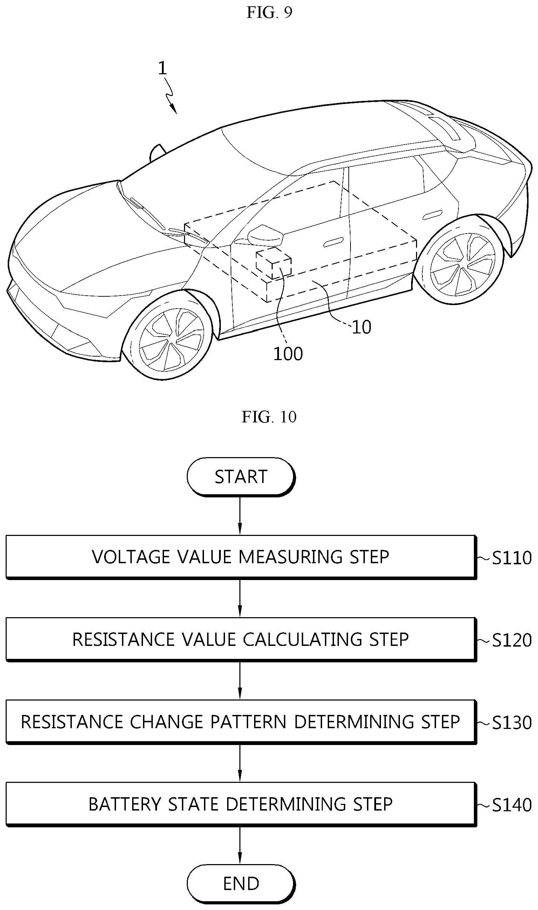

FIG. 9 is a diagram exemplarily showing a vehicle 1 including the apparatus 100 for diagnosing a battery according to the present disclosure. Referring to FIG. 9, the apparatus 100 for diagnosing a battery according to the present disclosure may be applied to an electric vehicle 1. That is, the electric vehicle 1 according to the present disclosure may include the apparatus 100 for diagnosing a battery according to the present disclosure. In particular, in the case of an electric vehicle, since a battery pack 10 is a very important component as a driving source, the apparatus 100 for diagnosing a battery according to the present disclosure may be more usefully applied. In addition, the electric vehicle 1 according to the present disclosure may further include various other devices, such as a vehicle body, a vehicle control unit such as an electronic control unit (ECU), a motor, a connection terminal, a DC-DC converter, and the like, in addition to the apparatus 100 for diagnosing a battery. In addition, the electric vehicle 1 according to the present disclosure may further employ components normally included in electric vehicles.

FIG. 10 is a diagram schematically showing a method for diagnosing a battery according to an embodiment of the present disclosure. In FIG. 10, the subject of each step may be each component of the apparatus 100 for diagnosing a battery according to the present disclosure described above.

Referring to FIG. 10, the method for diagnosing a battery according to the present disclosure may include a voltage value measuring step (S110), a resistance value calculating step (S120), a resistance change pattern determining step (S130), and a battery state determining step (S140).

Step S110 is a step of measuring the voltage value of the battery in the battery charging process, and may be performed by the measuring unit 110.

Specifically, the measuring unit 110 may measure the voltage value of the battery at each predetermined cycle.

For example, in the embodiment of FIG. 2, the processor 120 may apply a charging current to the battery in the form of a pulse at every predetermined cycle, and the measuring unit 110 may measure the voltage value of the battery while the pulse signal is applied to the battery.

Step S120 is a step of calculating the resistance value of the battery based on the voltage value of the battery measured in step S110, and may be performed by the processor 120.

For example, the processor 120 may calculate the resistance value based on the change in voltage value for the charging current amount corresponding to the pulse signal at every predetermined cycle.

Step S130 is a step of determining a resistance change pattern by comparing the plurality of resistance values calculated in step S120 with a preset criterion profile, and may be performed by the processor 120.

Specifically, the processor 120 may determine the resistance change pattern as the first resistance change pattern or the second resistance change pattern based on the result of comparing the plurality of resistance values and the criterion profile.

For example, the processor 120 may compare the first slope in the resistance profile indicating the change in the plurality of resistance values with the second slope in the criterion profile, and determine a resistance change pattern according to the comparison result.

Step S140 is a step of determining the state of the battery based on the resistance change pattern determined in step S130, and may be performed by the processor 120.

For example, if the resistance change pattern is determined to be the first resistance change pattern, the processor 120 may determine the state of the battery as a defective state. Conversely, if the resistance change pattern is determined to be the second resistance change pattern, the processor 120 may determine the state of the battery as a normal state.

In relation to the steps S110 to S140, the contents of the apparatus 100 for diagnosing a battery according to the present disclosure described above may be applied in the same or similar manner. Therefore, detailed descriptions of each step of the battery control method according to the present disclosure are omitted.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

100: apparatus for diagnosing a battery
110: measuring unit
120: processor
130: memory

## Claims

1. An apparatus for diagnosing a battery, comprising:
a measuring unit (110) configured to measure a voltage value of the battery at each predetermined cycle during a battery charging process; and
a processor (120) configured to calculate a plurality of resistance values of the battery based on the measured voltage values
of the battery, determine a resistance change pattern by comparing the calculated plurality of resistance values with a preset criterion profile (Rr), and determine the state of the battery based on the determined resistance change pattern,
wherein the processor (120) is configured to generate a resistance profile (Rd) representing the change in the calculated plurality of resistance values, and compare the generated resistance profile (Rd) with the criterion profile (Rr) to determine the resistance change pattern as a first resistance change pattern or a second resistance change pattern.

2. The apparatus for diagnosing a battery according to claim 1,
wherein the criterion profile (Rr) is a profile that represents the change in the plurality of resistance values calculated in a charging process of a criterion battery at each predetermined cycle.

3. The apparatus for diagnosing a battery according to claim 1,
wherein the processor (120) is configured to calculate a first slope from the resistance profile, calculate a second slope from the criterion profile, and determine the resistance change pattern according to the result of comparing the first slope and the second slope.

4. The apparatus for diagnosing a battery according to claim 1,
wherein when the first slope at a charging end time point on the resistance profile (Rd) is less than the second slope at a charging end time point on the criterion profile (Rr), the processor (120) is configured to determine the resistance change pattern as the first resistance change pattern, and
wherein when the first slope is greater than or equal to the second slope, the processor (120) is configured to determine the resistance change pattern as the second resistance change pattern.

5. The apparatus for diagnosing a battery according to claim 3,
wherein when the first slope based on a first point corresponding to a charging end time point on the resistance profile (Rd) and a second point different from the first point is less than the second slope based on a third point corresponding to the first point and a fourth point corresponding to the second point on the criterion profile (Rr), the processor (120) is configured to determine the resistance change pattern as the first resistance change pattern, and
wherein when the first slope is greater than or equal to the second slope, the processor (120) is configured to determine the resistance change pattern as the second resistance change pattern.

6. The apparatus for diagnosing a battery according to claim 5,
wherein the processor (120) is configured to generate a SOC-resistance profile (SOCd) that represents the correspondence relationship between a SOC of the battery and the calculated resistance value in the battery charging process, determine a target resistance value corresponding to the predetermined SOC in the SOC-resistance profile (SOCd), and determine a point corresponding to the target resistance value in the resistance profile (SOCd) as the second point.

7. The apparatus for diagnosing a battery according to claim 6,
wherein the processor (120) is configured to determine a reference resistance value corresponding to the predetermined SOC in a criterion SOC-resistance profile (SOCd) corresponding to the criterion profile (SOCr), and determine a point corresponding to the reference resistance value in the criterion profile (SOCr) as the fourth point.

8. The apparatus for diagnosing a battery according to claim 6,
wherein the processor (120) is configured to determine a peak belonging to a predetermined SOC section in a differential profile corresponding to the SOC of the battery and the voltage value of the battery, and determine a SOC corresponding to the determined peak as the predetermined SOC.

9. The apparatus for diagnosing a battery according to claim 1,
wherein when the resistance change pattern is the first resistance change pattern, the processor (120) is configured to determine that the battery is in a defective state, and
wherein when the resistance change pattern is the second resistance change pattern, the processor (120) is configured to determine that the battery is in a normal state.

10. The apparatus for diagnosing a battery according to claim 1,
wherein the processor (120) is configured to charge the battery while repeatedly changing a charging current value of the battery at every predetermined cycle, and calculate the resistance value based on the change in voltage value while the charging current value of the battery corresponds to a predetermined value.

11. A battery pack, comprising the apparatus for diagnosing a battery according to any one of claims 1 to 10.

12. A vehicle, comprising the apparatus for diagnosing a battery according to any one of claims 1 to 10.

13. A method for diagnosing a battery, comprising:
a voltage value measuring step (S110) of measuring a voltage value of the battery at each predetermined cycle during a battery charging process;
a resistance value calculating step (S120) of calculating a plurality of resistance values of the battery based on the measured voltage values of the battery;
a resistance change pattern determining step (S130) of determining a resistance change pattern by comparing the calculated plurality of resistance values with a preset criterion profile (Rr); and
a battery state determining step (S140) of determining the state of the battery based on the determined resistance change pattern,
wherein a resistance profile (Rd) is generated, representing the change in the calculated plurality of resistance values, and compare the generated resistance profile (Rd) with the criterion profile (Rr) to determine the resistance change pattern as a first resistance change pattern or a second resistance change pattern.

## Patentansprüche

1. Vorrichtung zum Diagnostizieren einer Batterie, aufweisend:
eine Messeinheit (110), die konfiguriert ist, einen Spannungswert der Batterie bei jedem vorbestimmten Zyklus während eines Batterieladeprozesses zu messen; und
einen Prozessor (120), der konfiguriert ist, mehrere Widerstandswerte der Batterie basierend auf den gemessenen Spannungswerten der Batterie zu berechnen, ein Widerstandsänderungsmuster durch Vergleichen der berechneten mehreren Widerstandswerte mit einem voreingestellten Kriteriumsprofil (Rr) zu bestimmen, und den Zustand der Batterie basierend auf dem bestimmten Widerstandsänderungsmuster zu bestimmen,
wobei der Prozessor (120) konfiguriert ist, ein Widerstandsprofil (Rd) zu erzeugen, das die Änderung in den berechneten mehreren Widerstandswerten darstellt, und das erzeugte Widerstandsprofil (Rd) mit dem Kriteriumsprofil (Rr) zu vergleichen, um das Widerstandsänderungsmuster als ein erstes Widerstandsänderungsmuster oder ein zweites Widerstandsänderungsmuster zu bestimmen.

2. Vorrichtung zum Diagnostizieren einer Batterie nach Anspruch 1,
wobei das Kriteriumsprofil (Rr) ein Profil ist, das die Änderung in den mehreren Widerstandswerten darstellt, die in einem Ladeprozess einer Kriteriumsbatterie bei jedem vorbestimmten Zyklus berechnet werden.

3. Vorrichtung zum Diagnostizieren einer Batterie nach Anspruch 1,
wobei der Prozessor (120) konfiguriert ist, eine erste Steigung aus dem Widerstandsprofil zu berechnen, eine zweite Steigung aus dem Kriteriumsprofil zu berechnen und das Widerstandsänderungsmuster gemäß dem Ergebnis des Vergleichs der ersten Steigung und der zweiten Steigung zu bestimmen.

4. Vorrichtung zum Diagnostizieren einer Batterie nach Anspruch 1,
wobei, wenn die erste Steigung zu einem Ladeendzeitpunkt auf dem Widerstandsprofil (Rd) kleiner als die zweite Steigung zu einem Ladeendzeitpunkt auf dem Kriteriumsprofil (Rr) ist, der Prozessor (120) konfiguriert ist, das Widerstandsänderungsmuster als das erste Widerstandsänderungsmuster zu bestimmen, und
wobei, wenn die erste Steigung größer oder gleich der zweiten Steigung ist, der Prozessor (120) konfiguriert ist, das Widerstandsänderungsmuster als das zweite Widerstandsänderungsmuster zu bestimmen.

5. Vorrichtung zum Diagnostizieren einer Batterie nach Anspruch 3,
wobei, wenn die erste Steigung basierend auf einem ersten Punkt, der einem Ladeendzeitpunkt auf dem Widerstandsprofil (Rd) entspricht, und einem zweiten Punkt, der von dem ersten Punkt verschieden ist, kleiner ist als die zweite Steigung basierend auf einem dritten Punkt, der dem ersten Punkt entspricht, und einem vierten Punkt, der dem zweiten Punkt auf dem Kriteriumsprofil (Rr) entspricht, wobei der Prozessor (120) konfiguriert ist, das Widerstandsänderungsmuster als das erste Widerstandsänderungsmuster zu bestimmen, und
wobei der Prozessor (120) konfiguriert ist, das Widerstandsänderungsmuster als das zweite Widerstandsänderungsmuster zu bestimmen, wenn die erste Steigung größer oder gleich der zweiten Steigung ist.

6. Vorrichtung zum Diagnostizieren einer Batterie nach Anspruch 5,
wobei der Prozessor (120) konfiguriert ist, ein SOC-Widerstandsprofil (SOCd) zu erzeugen, das die Entsprechungsbeziehung zwischen einem SOC der Batterie und dem berechneten Widerstandswert in dem Batterieladeprozess darstellt, einen Zielwiderstandswert, der dem vorbestimmten SOC in dem SOC-Widerstandsprofil (SOCd) entspricht, zu bestimmen und einen Punkt, der dem Zielwiderstandswert in dem Widerstandsprofil (SOCd) entspricht, als den zweiten Punkt zu bestimmen.

7. Vorrichtung zum Diagnostizieren einer Batterie nach Anspruch 6,
wobei der Prozessor (120) konfiguriert ist, einen Referenzwiderstandswert, der dem vorbestimmten SOC in einem Kriteriums-SOC-Widerstandsprofil (SOCd) entspricht, das dem Kriteriumsprofil (SOCr) entspricht, zu bestimmen und einen Punkt, der dem Referenzwiderstandswert in dem Kriteriumsprofil (SOCr) entspricht, als den vierten Punkt zu bestimmen.

8. Vorrichtung zum Diagnostizieren einer Batterie nach Anspruch 6,
wobei der Prozessor (120) konfiguriert ist, einen Höhepunkt, die zu einem vorbestimmten SOC-Abschnitt gehört, in einem Differenzprofil, das dem SOC der Batterie und dem Spannungswert der Batterie entspricht, zu bestimmen und einen SOC, der dem bestimmten Höhepunkt entspricht, als den vorbestimmten SOC zu bestimmen.

9. Vorrichtung zum Diagnostizieren einer Batterie nach Anspruch 1,
wobei, wenn das Widerstandsänderungsmuster das erste Widerstandsänderungsmuster ist, der Prozessor (120) konfiguriert ist, zu bestimmen, dass die Batterie in einem defekten Zustand ist, und
wobei, wenn das Widerstandsänderungsmuster das zweite Widerstandsänderungsmuster ist, der Prozessor (120) konfiguriert ist, zu bestimmen, dass die Batterie in einem normalen Zustand ist.

10. Vorrichtung zum Diagnostizieren einer Batterie nach Anspruch 1,
wobei der Prozessor (120) konfiguriert ist, die Batterie zu laden, während er wiederholt einen Ladestromwert der Batterie bei jedem vorbestimmten Zyklus ändert, und den Widerstandswert basierend auf der Änderung des Spannungswerts zu berechnen, während der Ladestromwert der Batterie einem vorbestimmten Wert entspricht.

11. Batteriepack, aufweisend die Vorrichtung zum Diagnostizieren einer Batterie nach einem der Ansprüche 1 bis 10.

12. Fahrzeug, aufweisend die Vorrichtung zum Diagnostizieren einer Batterie nach einem der Ansprüche 1 bis 10.

13. Verfahren zum Diagnostizieren einer Batterie, umfassend:
einen Spannungswertmessschritt (S110) zum Messen eines Spannungswerts der Batterie bei jedem vorbestimmten Zyklus während eines Batterieladeprozesses;
einen Widerstandswertberechnungsschritt (S120) zum Berechnen mehrerer Widerstandswerte der Batterie basierend auf den gemessenen Spannungswerten der Batterie;
einen Widerstandsänderungsmuster-Bestimmungsschritt (S130) zum Bestimmen eines Widerstandsänderungsmusters durch Vergleichen der berechneten mehreren Widerstandswerte mit einem voreingestellten Kriteriumsprofil (Rr); und
einen Batteriezustand-Bestimmungsschritt (S140) zum Bestimmen des Zustands der Batterie basierend auf dem bestimmten Widerstandsänderungsmuster,
wobei ein Widerstandsprofil (Rd) erzeugt wird, das die Änderung in den berechneten mehreren Widerstandswerten darstellt, und das erzeugte Widerstandsprofil (Rd) mit dem Kriteriumsprofil (Rr) vergleicht, um das Widerstandsänderungsmuster als ein erstes Widerstandsänderungsmuster oder ein zweites Widerstandsänderungsmuster zu bestimmen.

## Revendications

1. Appareil de diagnostic d'une batterie, comprenant :
un appareil de mesure (110) configuré pour mesurer une valeur de tension de la batterie à chaque cycle prédéterminé au cours d'un processus de charge de batterie ; et
un processeur (120) configuré pour calculer une pluralité de valeurs de résistance de la batterie d'après des valeurs de tension mesurées de la batterie, déterminer un modèle de changement de résistance en comparant la pluralité calculée de valeurs de résistance avec un profil de critère prédéfini (Rr), et déterminer l'état de la batterie d'après le modèle de changement de résistance déterminé,
le processeur (120) étant configuré pour générer un profil de la résistance (Rd) représentant la variation de la pluralité calculée de valeurs de résistance, et comparer le profil de la résistance (Rd) généré avec le profil de critère (Rr) afin de déterminer le modèle de changement de résistance en tant que premier modèle de changement de résistance ou deuxième modèle de changement de résistance.

2. Appareil de diagnostic d'une batterie selon la revendication 1,
le profil critère (Rr) étant un profil représentant la variation de la pluralité des valeurs de résistance calculées dans un processus de charge d'une batterie critère à chaque cycle prédéterminé.

3. Appareil de diagnostic d'une batterie selon la revendication 1,
le processeur (120) étant configuré pour calculer une première pente d'après le profil de résistance, calculer une deuxième pente d'après le profil de critère, et déterminer le modèle de changement de résistance en fonction du résultat de la comparaison entre la première pente et la deuxième pente.

4. Appareil de diagnostic d'une batterie selon la revendication 1,
dans lequel, lorsque la première pente en un repère temporel de fin de charge sur le profil de la résistance (Rd) est inférieure à la deuxième pente en un repère temporel de fin de charge sur le profil de critère (Rr), le processeur (120) est configuré pour déterminer le modèle de changement de résistance en tant que premier modèle de changement de résistance, et
lorsque la première pente est supérieure ou égale à la deuxième pente, le processeur (120) est configuré pour déterminer le modèle de changement de résistance en tant que deuxième modèle de changement de résistance.

5. Appareil de diagnostic d'une batterie selon la revendication 3,
dans lequel lorsque la première pente, basée sur un premier point correspondant à un repère temporel de fin de charge sur le profil de la résistance (Rd) et un deuxième point différent du premier point, est inférieure à la deuxième pente basée sur un troisième point correspondant au premier point et un quatrième point correspondant au deuxième point sur le profil de critère (Rr), le processeur (120) est configuré de façon à déterminer le modèle de changement de résistance en tant que premier modèle de changement de résistance, et
lorsque la première pente est supérieure ou égale à la deuxième pente, le processeur (120) étant configuré pour déterminer le modèle de changement de résistance en tant que deuxième modèle de changement de résistance.

6. Appareil de diagnostic d'une batterie selon la revendication 5,
le processeur (120) étant configuré pour générer un profil de résistance de l'état de charge (SOCd) représentant la relation de correspondance entre un état de charge de la batterie et la valeur de résistance calculée dans le processus de charge de la batterie, déterminer une valeur de résistance cible correspondant à l'état de charge prédéterminé dans le profil de résistance de l'état de charge (SOCd), et déterminer un point correspondant à la valeur de résistance cible dans le profil de résistance (SOCd) en tant que deuxième point.

7. Appareil de diagnostic d'une batterie selon la revendication 6,
le processeur (120) étant configuré pour déterminer une valeur de résistance de référence correspondant à l'état de charge (SOC) prédéterminé dans un profil de résistance de l'état de charge (SOCd) critère correspondant au profil de critère (SOCr), et déterminer un point correspondant à la valeur de résistance de référence dans le profil de critère (SOCr) en tant que quatrième point.

8. Appareil de diagnostic d'une batterie selon la revendication 6,
le processeur (120) étant configuré pour déterminer un pic appartenant à une section d'état de charge prédéterminée dans un profil différentiel correspondant à l'état de charge de la batterie et à la valeur de tension de la batterie, et déterminer un état de charge correspondant au pic déterminé en tant qu'état de charge prédéterminé.

9. Appareil de diagnostic d'une batterie selon la revendication 1,
dans lequel, lorsque le modèle de changement de résistance est le premier modèle de changement de résistance, le processeur (120) est configuré pour déterminer que la batterie se trouve dans un état défectueux, et
lorsque le modèle de changement de résistance est le deuxième modèle de changement de résistance, le processeur (120) est configuré pour déterminer que l'état de la batterie est normal.

10. Appareil de diagnostic d'une batterie selon la revendication 1,
le processeur (120) étant configuré pour charger la batterie tout en modifiant de façon répétée une valeur de courant de charge de la batterie à chaque cycle prédéterminé, et calculer la valeur de résistance en fonction de la variation de la valeur de tension tant que la valeur de courant de charge de la batterie correspond à une valeur prédéterminée.

11. Bloc-batterie comprenant l'appareil de diagnostic de la batterie selon une quelconque des revendications 1 à 10.

12. Véhicule comprenant l'appareil de diagnostic de la batterie selon une quelconque des revendications 1 à 10.

13. Procédé de diagnostic d'une batterie, comprenant :
une étape de mesure de la valeur de tension (S110) pour mesurer une valeur de tension de la batterie à chaque cycle prédéterminé au cours d'un processus de charge de batterie ;
une étape de calcul de la valeur de résistance (S120) consistant à calculer une pluralité de valeurs de résistance de la batterie d'après des valeurs de tension mesurées de la batterie ;
une étape de détermination d'un modèle de changement de résistance (S130) consistant à déterminer un modèle de changement de la résistance en comparant la pluralité de valeurs de résistance calculées avec un profil de critère prédéfini (Rr) ; et
une étape de détermination de l'état de la batterie (S140) consistant à déterminer l'état de la batterie d'après le modèle de changement de la résistance déterminé, un profil de la résistance (Rd) étant généré, et représentant la variation de la pluralité calculée de valeurs de résistance, et comparer le profil de la résistance généré (Rd) avec le profil de critère (Rr) afin de déterminer le modèle de changement de résistance en tant que premier modèle de changement de la résistance ou deuxième modèle de changement de la résistance.
